# FASCICULE DE BREVET EUROPEEN

(11) **EP 0 958 984 B1**
(45) Date de publication et mention de la délivrance du brevet: **10.03.2004**
(21) Numéro de dépôt: 99401065.0
(22) Date de dépôt: 30.04.1999
(51) Int. Cl.: B61F 15/28

(54) **Bougie de véhicule ferroviaire**
Drehgestell für ein Schienenfahrzeug
Railway vehicle bogie

(30) Priorité: 18.05.1998 FR 9806257; 09.06.1998 FR 9807245
(43) Date de publication de la demande: 24.11.1999
(73) Titulaire: Alstom France SA, 75116 Paris (FR)
(72) Inventeur: Auge de Fleury, Bernard, 93160 Noisy le Grand (FR); Bouttemy, Jean-Claude, 92130 Issy les Moulineaux (FR); Zliechovec, Jean-Yves, 95270 Seugy (FR)
(74) Mandataire: Moncheny, Michel

(56) Documents cités:
- DE-A- 4 313 753
- US-A- 5 289 120

## Description

La présente invention concerne un bogie de véhicule ferroviaire ainsi qu'un procédé d'usinage de ce bogie.

On connaît déjà dans l'état de la technique un bogie de véhicule ferroviaire du type comprenant un châssis fixe, au moins un essieu monté rotatif sur le châssis, un moteur électrique d'entraînement de l'essieu, un ensemble de retour de courant assurant le renvoi du courant provenant du moteur vers l'essieu, cet ensemble de retour de courant comportant une bague collectrice formant un épaulement solidaire de l'essieu, et un dispositif de mesure d'une grandeur physique liée à la rotation de l'essieu comportant un disque, solidaire de l'essieu, muni d'au moins un ajour formant repère, et un ensemble fixe de détection de ce repère, porté par le châssis.

De façon classique, le dispositif de mesure fournit une grandeur physique liée au déplacement angulaire du disque qui permet de déduire notamment la distance parcourue par le véhicule ferroviaire ou bien la vitesse de ce véhicule.

Habituellement, le dispositif de mesure comporte un ensemble de détection optique et se présente sous la forme d'un module pré-assemblé destiné à être monté sur une extrémité libre d'un essieu de bogie. L'ensemble de détection optique et le disque sont protégés contre les poussières et salissures par des moyens d'étanchéité appropriés. Un tel module pré-assemblé peut avantageusement être agencé sur un bogie sans démontage de ce dernier.

Dans certains cas, le montage du module pré-assemblé sur l'extrémité libre d'un essieu de bogie est interdit ou impossible. Or, il est difficile d'adapter un tel module pour permettre son agencement sur une autre partie de l'essieu, ceci pour des raisons notamment de montage peu aisé, d'encombrement et/ou de protection contre l'eau, les poussières et les salissures susceptibles d'entraver le bon fonctionnement de l'ensemble de détection optique.

L'invention a pour but d'agencer sur un bogie un dispositif permettant une mesure fiable d'une grandeur physique liée à la rotation de l'essieu de ce bogie, ceci sans démontage de ce dernier.

A cet effet, l'invention a pour objet un bogie de véhicule ferroviaire conforme à la revendication 1.

D'autres caractéristiques de ce bogie sont indiquées dans les revendications dépendantes:

L'invention a également pour objet un procédé de réalisation du bogie conforme à l'invention.

Une autre caractéristique de ce procédé est indiquée dans la revendication dépendante de procédé.

L'invention sera mieux comprise à la lecture de la description qui va suivre donnée uniquement à titre d'exemple et faite en se référant aux dessins dans lesquels :
- la figure 1 est une vue schématique d'un bogie selon l'invention ;
- la figure 2 est une vue en coupe, à échelle agrandie, suivant la ligne 2-2 de la figure 1 ;
- la figure 3 est une vue du disque du dispositif de mesure, suivant la flèche 3 de la figure 4, avec des coupes partielles ;
- la figure 4 est une vue suivant la flèche 4 de la figure 3 ;
- la figure 5 est une vue similaire à la figure 2 dans laquelle un outil de guidage est agencé en lieu et place du disque ;
- la figure 6 est une vue en coupe suivant la ligne 6-6 de la figure 5 ;
- la figure 7 est une vue schématique de l'ensemble de détection porté par le bogie ;
- les figures 8 et 9 sont des vues schématiques d'une spire de contrôle d'un détecteur de l'ensemble représenté à la figure 7 reliée à des moyens de modification de son état, respectivement, par mise en court-circuit et alimentation en courant ;
- la figure 10 est une vue similaire à la figure 2 montrant une variante de réalisation de moyens de centrage du disque par rapport à un essieu du bogie.

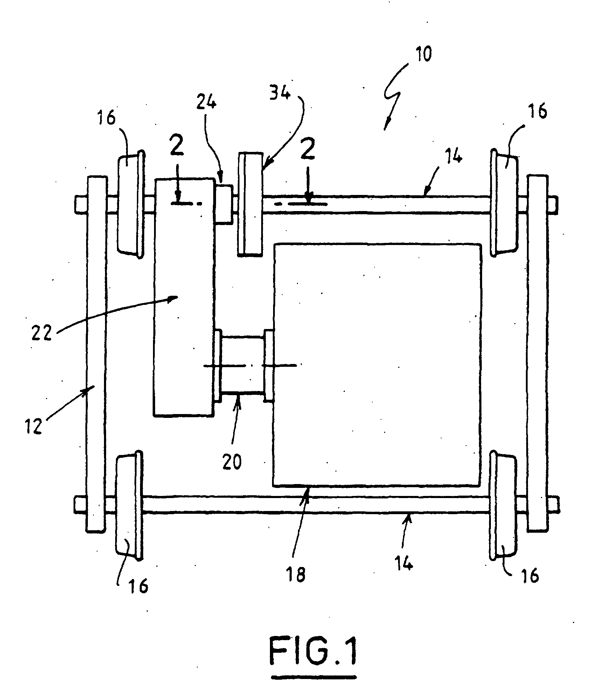

On a représenté schématiquement sur la figure 1 un bogie de véhicule ferroviaire désigné par la référence générale 10.

De façon classique, ce bogie comporte un châssis fixe 12 et une paire d'essieux 14, portant des roues 16, montés rotatifs sur ce châssis 12. Le bogie 10 comporte également un moteur électrique d'entraînement classique 18 relié à un essieu 14 par l'intermédiaire de dispositifs de couplage 20 et de réduction 22. Le bogie 10 comporte encore un ensemble classique 24 de retour de courant d'alimentation du moteur 18. Cet ensemble 24 assure le renvoi du courant provenant du moteur 18 vers l'essieu 14 couplé au dispositif de réduction 22, ceci à l'aide de moyens classiques de contact électrique par frottement.

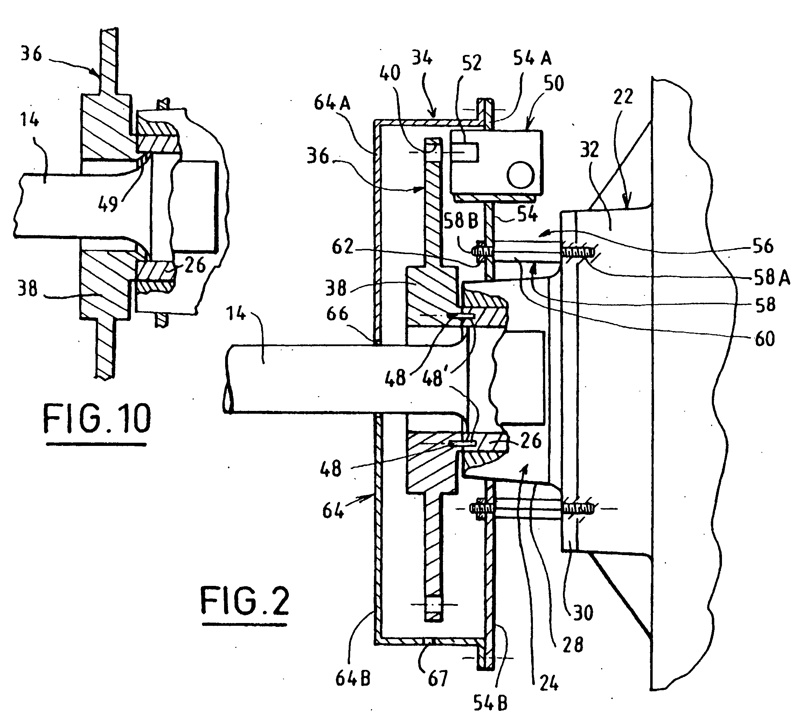

En se référant à la figure 2, on voit que l'ensemble de retour de courant 24 comporte une bague collectrice 26 formant un épaulement solidaire de l'essieu 14. L'ensemble de retour de courant 24 comporte également un boîtier fixe 28, entourant la bague collectrice 26, muni d'un flasque de fixation 30. Ce flasque 30 est fixé par des moyens qui seront décrits ultérieurement à un boîtier fixe 32 du dispositif de réduction 22 porté par le châssis 12.

Le bogie 10 comporte de plus un dispositif 34 de mesure d'une grandeur physique liée à la rotation de l'essieu 14 représenté en détail sur les figures 2 à 4. Ce dispositif de mesure 34 comporte un disque métallique 36 solidaire de l'essieu 14 et coaxial à ce dernier.

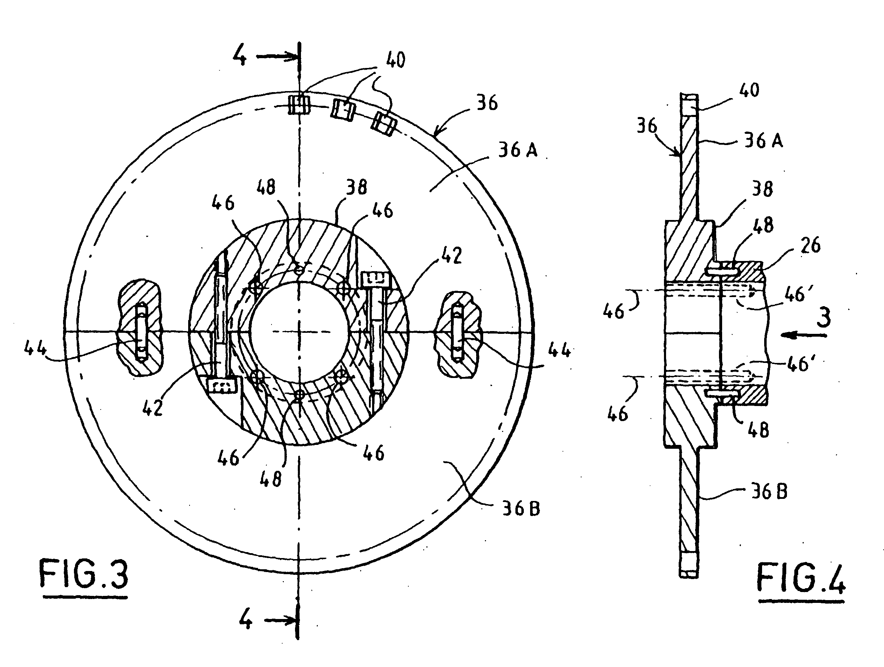

Le disque 36 comporte un moyeu 38 et au moins un ajour 40 formant repère. De préférence, le disque 36 comporte n ajours 40 répartis régulièrement sur un cercle centré sur son axe, n étant un entier non nul. Pour des raisons de simplification seulement trois ajours 40 sont représentés sur la figure 3.

Les ajours 40 sont formés, par exemple, par des orifices traversant l'épaisseur du disque, comme cela est représenté notamment sur les figures 2 et 3, ou par des encoches débouchant à la périphérie de ce disque.

Afin de permettre son montage autour de l'essieu 14, le disque 36 comporte au moins deux parties 36A,36B formant deux secteurs s'étendant chacun de préférence sur environ 180°, reliées entre elles par une paire de vis 42 et une paire de pions de centrage 44 sensiblement parallèles aux faces du disque 36 (voir figure 3).

Le moyeu 38 du disque est fixé sur une face libre de la bague collectrice 26 au moyen de vis 46 (schématisées par des traits interrompus sur la figure 4) et de pions de centrage 48 sensiblement perpendiculaires aux faces du disque 36 et parallèles à l'axe de l'essieu 14 (voir notamment figures 3 et 4).

Dans l'exemple illustré sur les figures, le moyeu 38 du disque est fixé sur la bague collectrice 26 au moyen de quatre vis 46 et de deux pions de centrage 48, à savoir deux vis 46 et un pion de centrage 48 par partie 36A,36B du disque.

En variante, les pions de centrage 48 peuvent être remplacés par d'autres moyens de centrage par rapport à l'essieu 14, par exemple un épaulement 49 usiné dans le moyeu 38 du disque coopérant avec le contour intérieur de la bague collectrice 26, comme cela est représenté sur la figure 10.

Le dispositif de mesure 34 comporte de plus un ensemble fixe 50 de détection des ajours 40 du disque 36.

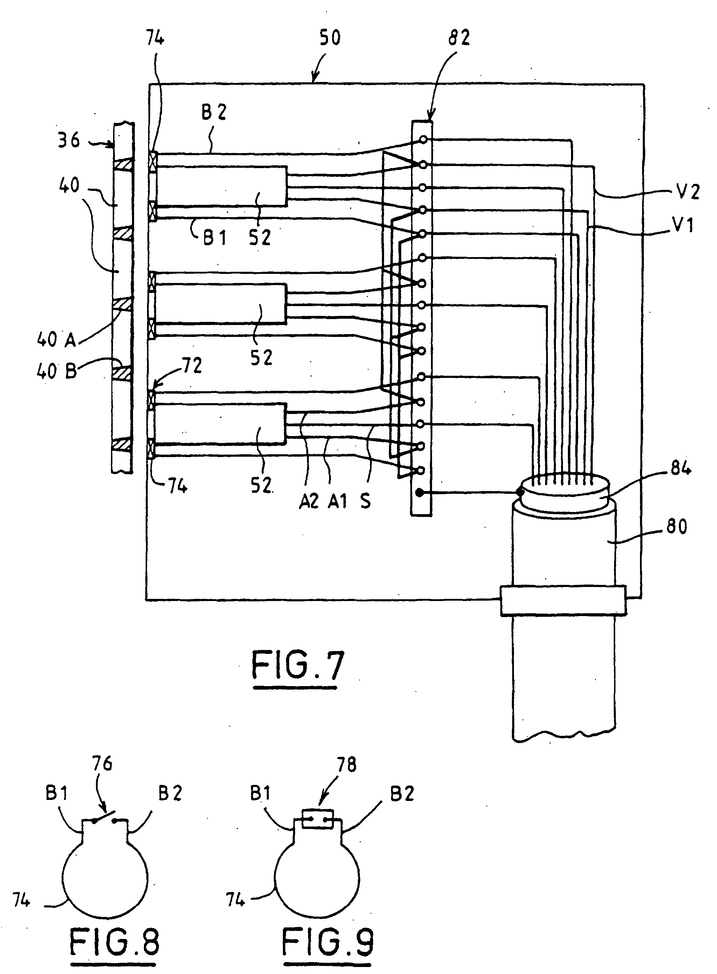

Cet ensemble de détection 50, représenté plus en détail sur la figure 7, comprend au moins un détecteur magnétique de proximité 52, par exemple trois comme illustré ou p, p étant un entier non nul, répartis régulièrement sur un arc de cercle en regard des ajours 40.

Les détecteurs 52 sont de type connu, par exemple de type inductif commercialisé par la société OMROM ELECTRONICS sous la référence E2EG. Ces détecteurs inductifs fonctionnent en utilisant le principe des courants de Foucault.

Les dimensions et les espacements angulaires des ajours 40 et des détecteurs 52 sont tels qu'il existe toujours un détecteur 52 en regard d'un ajour 40 quelle que soit la position angulaire du disque par rapport à l'ensemble de détection 50.

De préférence, afin d'empêcher l'accumulation de poussière dans les ajours 40, ces derniers sont délimités chacun par deux surfaces sensiblement radiales 40A,40B convergentes vers la face du disque 36 en regard de l'ensemble de détection 50, comme cela est représenté sur la figure 7.

L'ensemble de détection 50, qui sera décrit plus en détail ultérieurement, est porté par une platine fixe 54 (voir figure 2). Le flasque 30 du boîtier 28 de l'ensemble de retour de courant et là platine 54 sont reliés par au moins un organe de fixation commun 56, de préférence quatre, au boîtier 32 du dispositif de réduction. Ce boîtier 32 forme donc un support, porté par le châssis du bogie, commun au flasque 30 de l'ensemble de retour de courant et à la platine 54.

Chaque organe de fixation 56 comprend un goujon 58 muni de deux extrémités filetées 58A,58B et d'un corps polygonal de manoeuvre 60 espaçant le flasque 30 de la platine 54. Une première extrémité 58A du goujon, traversant le flasque 30 du boîtier 28, est vissée dans le boîtier 32 du dispositif de réduction. La seconde extrémité 58B du goujon, traversant la platine 54, est vissée dans un écrou de serrage 62.

Le disque 36 est recouvert par un capot de protection 64 relié, de façon connue en soi, à la platine 54.

Afin de permettre leur montage autour de l'essieu 14, la platine 54 et le capot 64 comprennent chacun au moins deux parties 54A,54B,64A,64B, formant deux secteurs s'étendant de préférence sur environ 180°.

On comprend donc que la platine 54 et le capot 64 forment un carter protégeant le disque 36 et l'ensemble de détection 50 contre les poussières et salissures environnantes ainsi que les projections d'eau sous le bogie.

Toutefois, on notera la présence d'un jeu radial 66 entre l'essieu rotatif 14 et la paroi du capot 64 traversée par cet essieu. Ce jeu radial 66 permet de tenir compte des tolérances de fabrication de l'essieu 14 et du capot 64.

Les poussières et salissures pénétrant le cas échéant, par le jeu 66, dans le carter formé par la platine 54 et le capot 64 ne sont pas susceptibles de perturber le bon fonctionnement des détecteurs inductifs de proximité 52 qui sont beaucoup moins sensibles aux poussières et salissures que les détecteurs optiques. Par ailleurs, l'eau susceptible de pénétrer dans le carter est évacuée naturellement par un trou 67 percé dans le bas du capot 64 (voir figure 2).

Le capot 64 assure donc une étanchéité suffisante pour garantir un bon fonctionnement des détecteurs inductifs de proximité 52. Il n'est donc pas nécessaire de recourir à des moyens d'étanchéité complexes et encombrants tels que ceux associés habituellement aux ensembles de détection optiques classiques.

On décrira ci-dessous un procédé d'usinage des moyens de fixation du disque 36 sur la face libre de la bague collectrice 26.

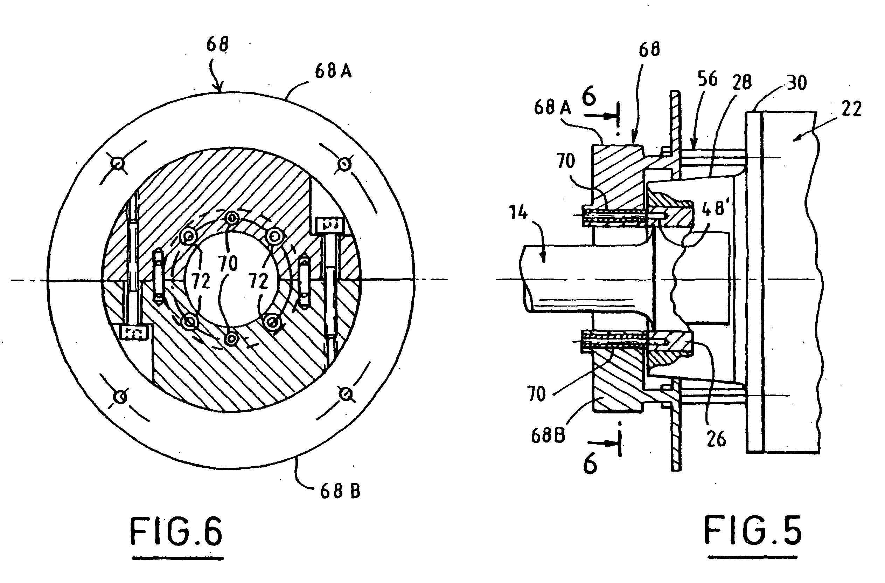

Tout d'abord, on fixe temporairement sur le boîtier 22 du dispositif de réduction un outil de guidage 68 de forme générale annulaire (voir figures 5 et 6), ceci au moyen des organes de fixation communs 56, en lieu et place de la platine 54.

Afin de permettre son montage autour de l'essieu 14, l'outil 68 comporte au moins deux parties 68A,68B formant deux secteurs s'étendant chacun de préférence sur environ 180°. Ces deux parties 68A,68B sont reliées entre elles par des moyens analogues à ceux reliant les deux parties 36A,36B du disque (voir figure 6).

L'outil de guidage 68 est centré par rapport à l'axe de l'essieu 14 à l'aide de moyens classiques.

Après avoir fixé et centré l'outil de guidage 68, on forme dans la face libre de la bague collectrice 26 des orifices de centrage 48' destinés à recevoir les pions de centrage 48 du disque (voir figure 2), et s'il n'en existe pas déjà, des orifices taraudés 46' destinés à recevoir les vis de fixation 46 du disque (voir figure 4), ceci au moyen d'un outil de perçage classique (non représenté) guidé par des canons de perçage 70,72 portés par l'outil de guidage 68.

Après avoir percé les orifices de centrage 48' et taraudés 46', on retire l'outil de guidage 68 et l'on fixe le disque 36 sur la face libre de la bague 26 avec les moyens décrits précédemment.

En variante, dans le cas où la face libre de la bague collectrice 26 comporte déjà des orifices taraudés, ces derniers forment alors les orifices 46' et l'outil d'usinage 68 peut être fixé temporairement sur la face libre de la bague au moyen de vis vissées dans ces orifices taraudés pré-existants, afin de pouvoir former les orifices de centrage 48'.

Il ressort donc de ce qui précède et plus particulièrement du procédé d'usinage décrit ci-dessus que le dispositif de mesure 34 peut être monté sur le bogie 10 sans démontage de ce dernier.

On décrira ci-dessous plus en détail l'ensemble de détection 50, en se référant aux figures 7 à 9.

On notera que les détecteurs 52 décrits sont de type inductif. Toutefois tout autre type de détecteur magnétique pourrait être utilisé dans le cadre de l'invention par exemple des détecteurs à effet Hall.

De façon classique, chaque détecteur inductif 52 est raccordé électriquement à deux conducteurs d'alimentation électrique A1,A2 et à un conducteur de signal de sortie S.

Chaque détecteur inductif 52 comporte des moyens 72 de contrôle de son bon fonctionnement. Ces moyens 72 sont agencés à l'extérieur du détecteur inductif, sans contact ou raccordement électrique avec ce dernier.

De préférence, les moyens de contrôle 72 comprennent au moins une spire conductrice 74 entourant une extrémité active du détecteur 52. Cette spire 74 est raccordée à des moyens de modification de son état. De tels moyens de modification d'état sont constitués, par exemple, par des moyens classiques de mise en court-circuit de la spire 74, comportant notamment un commutateur 76, comme cela est illustré sur la figure 8, ou bien par des moyens classiques 78 d'alimentation en courant de la spire 74, comme cela est illustré sur la figure 9.

En variante, la spire 74 peut être remplacée par une bobine conductrice constituée de plusieurs spires.

Chaque spire 74 est raccordée à des conducteurs d'entrée B1 et de sortie B2.

L'ensemble des conducteurs A1,A2,S,B1,B2 est raccordé à un câble multi-conducteurs 80 par l'intermédiaire d'un bornier 82.

On notera que les conducteurs d'alimentation A1,A2 des détecteurs 52 sont raccordés en parallèle entre eux et à deux conducteurs d'alimentation V1,V2 du câble 80. On notera également que les conducteurs d'entrée B1 des spires 74 sont raccordés à un point commun du bornier 82. On notera enfin que le câble 80 comporte un blindage 84 également raccordé au bornier 82.

De façon classique, chacun des détecteurs inductifs 52 comporte un oscillateur (non représenté) associé à un circuit électronique de détection. Le signal de sortie émis par le détecteur 52 est de type binaire (un niveau haut et un niveau bas). Le passage d'un élément métallique (portion de disque séparant deux ajours 40) devant le détecteur 52 modifie l'état de son oscillateur et provoque un changement de niveau du signal de sortie.

Lorsqu'un détecteur 52 est en fonctionnement et que son extrémité active est écartée de tout élément métallique perturbateur, la modification de l'état de la spire 74 associée à ce détecteur, par mise en court-circuit ou par alimentation en courant, provoque un changement de niveau du signal de sortie comme le ferait un élément métallique passant devant le détecteur 52.

Les moyens de contrôle 72 permettent donc de contrôler le dispositif de mesure 34 de la façon suivante.

Le disque 36 étant immobile par rapport à l'ensemble de détection 50, on modifie suivant une séquence de référence l'état de la spire 74 d'au moins un détecteur en fonctionnement et en regard d'un ajour 40. Il convient de rappeler que les dimensions et les espacements angulaires des ajours 40 et des détecteurs 52 sont tels qu'il existe toujours un détecteur en regard d'un ajour 40 quelle que soit la position angulaire du disque 36 par rapport à l'ensemble de détection 50.

La séquence de référence est comparée avec le signal de sortie du détecteur contrôlé de façon à vérifier que le niveau de ce signal change suivant une séquence identique à celle de référence. Dans le cas contraire, on peut conclure à un défaut de fonctionnement du détecteur 52 contrôlé.

On notera que le procédé décrit ci-dessus de contrôle d'un détecteur 52 permet de déceler tout déplacement accidentel du disque 36 par le fait qu'un tel déplacement engendre une disparité entre la séquence de référence et la séquence de changement de niveau du signal de sortie.

Tout déplacement accidentel d'un bogie et donc d'un véhicule ferroviaire pendant le procédé ci-dessus de contrôle d'un détecteur 52 peut donc être facilement détecté.

Les moyens de contrôle 72, indépendants du fonctionnement des détecteurs 52, permettent donc de réaliser un contrôle très fiable et sécuritaire de ces derniers.

## Revendications

1. Bogie de véhicule ferroviaire du type comprenant
un châssis fixe (12),
au moins un essieu (14) monté rotatif sur le châssis (12),
un moteur électrique (18) d'entraînement de l'essieu,
un ensemble (24) de retour de courant assurant le renvoi du courant provenant du moteur (18) vers l'essieu (14), cet ensemble de retour de courant (24) comportant une bague collectrice (26) formant un épaulement solidaire de l'essieu (14), et
un dispositif de mesure (34) d'une grandeur physique liée à la rotation de l'essieu (14) comportant un disque (36), solidaire de l'essieu (14), muni d'au moins un ajour (40) formant repère, et un ensemble fixe (50) de détection de ce repère, porté par le châssis,
**caractérisé en ce que** le disque (36) est métallique et est fixé sur une face libre de la bague collectrice (26) au moyen de vis (46) sensiblement perpendiculaires aux faces du disque (36) et parallèles à l'axe de l'essieu (14) et de moyens de centrage (48;49) par rapport à l'essieu (14), l'ensemble de détection (50) comportant au moins un détecteur inductif de proximité (52).

2. Bogie selon la revendication 1, **caractérisé en ce que** les moyens de centrage comprennent des pions (48) sensiblement parallèles à l'axe de l'essieu (14) ou un épaulement (49) du disque (36) coopérant avec le contour intérieur de la bague collectrice (26).

3. Bogie selon l'une quelconque des revendications précédentes, **caractérisé en ce que** l'ensemble de retour de courant (24) comprend un boîtier fixe (28), entourant la bague collectrice (26), muni d'un flasque de fixation (30),
**en ce que** l'ensemble de détection (50) est porté par une platine fixe (54), et
**en ce que** le flasque de fixation (30) et la platine (54) sont reliés par au moins un organe de fixation commun (56) à un support commun (32) porté par le châssis (12).

4. Bogie selon la revendication 3, **caractérisé en ce que** l'organe de fixation commun (56) comporte un goujon (58) muni de deux extrémités filetées (58A,58B) et d'un corps de manoeuvre espaçant le flasque de fixation (30) et la platine (54), une première extrémité (58A) du goujon, traversant le flasque de fixation (30), étant vissée dans le support commun (32), la seconde extrémité (58B) du goujon, traversant la platine (54), étant vissée dans un écrou de serrage (62).

5. Bogie selon la revendication 3 ou 4, **caractérisé en ce que** le support commun est un boîtier (32) d'un dispositif de réduction (22) couplé au moteur électrique (18).

6. Bogie selon l'une quelconque des revendications 3 à 5, **caractérisé en ce que** le disque (36) est recouvert par un capot de protection (64) relié à la platine (54).

7. Bogie selon l'une quelconque des revendications précédentes, **caractérisé en ce que** le disque (36) comporte au moins deux parties (36A,36B) formant deux secteurs s'étendant chacun de préférence sur environ 180°, reliées entre elles par des vis (42) et des pions de centrage (44) sensiblement parallèles aux faces du disque (36).

8. Bogie selon la revendication 6, **caractérisé en ce que** la platine (54) et le capot (64) comprennent chacun au moins deux parties (54A,54B,64A,64B) formant deux secteurs s'étendant de préférence sur environ 180°.

9. Bogie selon l'une quelconque des revendications précédentes, **caractérisé en ce que** l'ajour (40) est délimité par deux surfaces (40A,40B) sensiblement radiales convergeantes vers la face du disque (36) en regard de l'ensemble de détection (50).

10. Procédé de réalisation d'un bogie de véhicule ferroviaire conforme à l'une quelconque des revendications précédentes, **caractérisé :**
- **en ce que** l'on forme dans la face libre de la bague collectrice (26) des orifices de centrage (48') destinés à recevoir des pions de centrage (48) du disque (36), ou des orifices taraudés (46') destinés à recevoir des vis de fixation (46) du disque (36), ceci au moyen d'un outil de perçage guidé par des canons de perçage (70) portés par un outil de guidage (68), de forme générale annulaire, fixé temporairement et centré par rapport à l'axe de l'essieu (14), et
- **en ce que** l'on fixe les deux parties du disque métallique (36) sur une face libre de la bague collectrice (26) au moyen de vis de fixation (46) sensiblement perpendiculaires aux faces du disque (36) et parallèles à l'axe de l'essieu (14), et de pions de centrage (48) par rapport à l'essieu (14).

11. Procédé selon la revendication 10 pour réaliser un bogie de véhicule ferroviaire conforme aux revendications 2 et 3 prises ensemble, **caractérisé en ce que** l'outil de guidage (68) est fixé
soit sur la face libre de la bague collectrice (26) au moyen de vis vissées dans des orifices taraudés pré-existants dans cette face libre,
soit sur le support commun (32) au moyen de l'organe de fixation commun (56), en lieu et place de la platine (54).

## Claims

1. Bogie for a rail vehicle of the type comprising
a fixed chassis (12),
at least one axle (14) rotatably mounted on the chassis (12),
an electric motor (18) for driving the axle,
a current return unit (24) ensuring that the current from the motor (18) is returned towards the axle (14), this current return unit (24) comprising a collecting ring (26) forming a shoulder which is solidly attached to the axle (14), and
a device (34) for measuring a physical variable associated with the rotation of the axle (14) comprising a disc (36), solidly attached to the axle (14), provided with at least one opening (40) forming a marker, and a fixed unit (50) for detecting this marker, carried by the chassis,
**characterised in that** the disc (36) is made of metal and is fixed to a free side of the collecting ring (26) by means of screws (46) substantially perpendicular to the sides of the disc (36) and parallel to the axis of the axle (14) and centring means (48,49) for centring relative to the axle (14), the detecting unit (50) comprising at least one inductive proximity detector (52).

2. Bogie according to claim 1, **characterised in that** the centring means comprise studs (48) substantially parallel to the axis of the axle (14) or a shoulder (49) of the disc (36) cooperating with the inner contour of the collecting ring (26).

3. Bogie according to one of the preceding claims, **characterised in that** the current return unit (24) comprises a fixed housing (28) surrounding the collecting ring (26), provided with a fixing cheek (30), **in that** the detecting unit (50) is carried by a fixed plate (54) and
**in that** the fixing cheek (30) and the plate (54) are connected by at least one common fixing member (56) to a common support (32) carried by the chassis (12).

4. Bogie according to claim 3, **characterised in that** the common fixing member (56) comprises a pin (58) having two threaded ends (58A, 58B) and a manoeuvring body which spaces the fixing cheek (30) and the plate (54), a first end (58) of the pin, passing through the fixing cheek (30), being screwed into the common support (32), the second end (58B) of the pin, passing through the plate (54), being screwed into a clamping nut (62).

5. Bogie according to claim 3 or 4, **characterised in that** the common support is a housing (32) of a stepping-down device (22) coupled to the electric motor (18).

6. Bogie according to any one of claims 3 to 5, **characterised in that** the disc (36) is covered by a protective cowling (64) connected to the plate (54).

7. Bogie according to any one of the preceding claims, **characterised in that** the disc (36) has at least two parts (36A, 36B) forming two sectors each preferably extending over approximately 180°, connected to one another by screws (42) and centring studs (44) which are substantially parallel to the sides of the disc (36).

8. Bogie according to claim 6, **characterised in that** the plate (54) and the cowling (64) each have at least two parts (54A, 54B, 64A, 64B) forming two sectors preferably extending over approximately 180°.

9. Bogie according to any one of the preceding claims, **characterised in that** the opening (40) is delimited by two substantially radial surfaces (40A, 40B) converging towards the side of the disc (36) opposite the detecting unit (50).

10. Process for producing a bogie for a rail vehicle according to any one of the preceding claims,
**characterised in that**:
- in the free side of the collecting ring (26) centring holes (48') are formed which are adapted to receive the centring studs (48) of the disc (36), or tapped holes (46') which are adapted to receive fixing screws (46) for the disc (36), by means of a drilling tool guided by drilling barrels (70) supported by a guide tool (68), of generally annular shape, temporarily fixed and centred relative to the axis of the axle (14), and
- the two parts of the metal disc (36) are fixed to a free side of the collecting ring (26) by means of fixing screws (46) substantially perpendicular to the sides of the disc (36) and parallel to the axis of the axle (14), and centring studs (48) relative to the axle (14).

11. Process according to claim 10 for manufacturing a rail vehicle bogie according to claims 2 and 3 taken together, **characterised in that** the guide tool (68) is fixed
either to the free side of the collecting ring (26) by means of screws screwed into pre-existing tapped holes in this free side,
or to the common support (32) by means of the common fixing member (56), instead of the plate (54).

## Patentansprüche

1. Drehgestell für Eisenbahnfahrzeug der Art mit
einem festen Rahmen (12),
zumindest einer drehbar an dem Rahmen (12) angebrachten Achse (14)
einem elektrischen Antriebsmotor (18) für die Achse,
einer Stromübertragungsanordnung (24), welche die Übertragung des aus dem Motor (18) stammenden Stroms auf die Achse (14) sicherstellt, wobei die Stromübertragungsanordnung (24) einen Schleifring (26) aufweist, der einen einstückig mit der Achse (14) ausgebildeten Ansatz bildet, und
einer Messvorrichtung (34) für eine mit der Drehung der Achse (14) zusammenhängende physikalische Größe, mit einer einstückig mit der Achse (14) ausgebildeten Scheibe (36), die mit wenigstens einem einen Bezugspunkt bildenden Durchbruch (40) versehen ist, und mit einer festen Erfassungseinheit (50) für diesen Bezugspunkt, die von dem Rahmen getragen ist,
**dadurch gekennzeichnet, dass** die Scheibe (36) aus Metall besteht und auf einer freien Fläche des Schleifrings (26) mittels Schrauben (46), die praktisch senkrecht zu den Flächen der Scheibe (36) und parallel zu der Achse der Tragachse (14) liegen, und mittels Zentriervorrichtungen (48; 49) bezüglich der Achse (14) befestigt ist; wobei die Erfassungseinheit (50) zumindest einen induktiven Näherungsschalter (52) aufweist.

2. Drehgestell gemäß Anspruch 1, **dadurch gekennzeichnet, dass** die Zentriervorrichtungen praktisch parallel zu der Achse der Tragachse (14) liegende Pione (48) oder einen Ansatz (49) der Scheibe (36) aufweisen, der mit der Innenkontur des Schleifrings (26) zusammenwirkt.

3. Drehgestell gemäß irgendeinem der vorherigen Ansprüche, **dadurch gekennzeichnet, dass** die Stromübertragungsanordnung (24) ein festes Gehäuse (28) aufweist, welches den Schleifring (26) umgibt, und welches mit einem Befestigungsflansch (30) versehen ist,
dass die Erfassungseinheit (50) von einer festen Tragplatte (54) getragen ist, und
dass der Befestigungsflansch (30) und die Tragplatte (54) durch zumindest ein gemeinsames Befestigungsorgan (56) mit einem von dem Rahmen (12) getragenen, gemeinsamen Träger (32) verbunden sind.

4. Drehgestell gemäß Anspruch 3, **dadurch gekennzeichnet, dass** das gemeinsame Befestigungsorgan (56) einen Stiftbolzen (58) aufweist, der mit zwei gewindeten Enden (58A, 58B) und einem Betätigungskörper versehen ist, welcher den Befestigungsflansch (30) und die Tragplatte (54) beabstandet voneinander hält, wobei ein erstes Ende (58A) des Stiftbolzens, welches den Befestigungsflansch (30) durchquert, in dem gemeinsamen Träger (32) verschraubt ist, wobei das zweite Ende (58B) des Stiftbolzens, das die Tragplatte (54) durchquert, in einer Stellmutter (62) verschraubt ist.

5. Drehgestell gemäß Anspruch 3 oder 4, **dadurch gekennzeichnet, dass** der gemeinsame Träger ein Gehäuse (32) einer Untersetzungsvorrichtung (22) ist, die an den elektrischen Motor (18) gekoppelt ist.

6. Drehgestell gemäß irgendeinem der Ansprüche 3 bis 5, **dadurch gekennzeichnet, dass** die Scheibe (36) von einer mit der Tragplatte (54) verbundenen Schutzhaube (64) abgedeckt ist.

7. Drehgestell gemäß irgendeinem der vorherigen Ansprüche, **dadurch gekennzeichnet, dass** die Scheibe (36) zumindest zwei Bereiche (36A, 36B) umfasst, die zwei Sektoren bilden, die sich jeweils vorzugsweise über ungefähr 180° erstrecken, wobei die Bereiche miteinander über Schrauben (42) und Zentrierpione (44) verbunden sind, welche praktisch parallel zu den Flächen der Scheibe (36) liegen.

8. Drehgestell gemäß Anspruch 6, **dadurch gekennzeichnet, dass** die Tragplatte (54) und die Haube (64) jeweils zumindest zwei Bereiche (54A, 54B, 64A, 64B) umfassen, die zwei Sektoren bilden, die sich vorzugsweise über ungefähr 180° erstrecken.

9. Drehgestell gemäß irgendeinem der vorherigen Ansprüche, **dadurch gekennzeichnet, dass** der Durchbruch (40) von zwei praktisch radialen Flächen (40A, 40B) begrenzt ist, die zu der Vorderseite der Scheibe (36) gegenüber der Erfassungseinheit (50) hin konvergieren.

10. Verfahren zur Herstellung eines Drehgestells für Eisenbahnfahrzeuge gemäß irgendeinem der vorherigen Ansprüche, **dadurch gekennzeichnet, dass**:
- in der freien Fläche des Schleifrings (26) Zentrieröffnungen (48'), die dafür bestimmt sind, die Zentrierpione (48) der Scheibe (36) aufzunehmen, oder mit Gewinde versehene Öffnungen (46') ausgebildet werden, die dafür bestimmt sind, die Befestigungsschrauben (46) der Scheibe (36) aufzunehmen, und zwar mit Hilfe eines Bohrwerkzeugs, das von Bohrhülsen (70) geführt wird, die von einem Führungswerkzeug (68) mit allgemeiner ringförmiger Form getragen sind, das vorübergehend an der Achse der Tragachse (14) befestigt und bezüglich dieser zentriert ist, und
- die beiden Bereiche der Metallscheibe (36) auf einer freien Fläche des Schleifrings (26) mit Hilfe von praktisch senkrecht zu den Flächen der Scheibe (36) und parallel zu der Achse der Tragachse (14) liegenden Befestigungsschrauben (46) und mit Hilfe von Zentrierpionen (48) bezüglich der Achse (14) befestigt werden.

11. Verfahren gemäß Anspruch 10 zur Herstellung eines Drehgestells für Eisenbahnfahrzeuge gemäß den Ansprüchen 2 und 3 in Kombination, **dadurch gekennzeichnet, dass** das Führungswerkzeug (68) befestigt wird
entweder auf der freien Fläche des Schleifrings (26) mit Hilfe von Schrauben, die in zuvor in dieser freien Fläche bestehenden, mit Gewinde versehenen Öffnungen verschraubt werden,
oder auf dem gemeinsamen Träger (32) mit Hilfe des gemeinsamen Befestigungsorgans (56) an Ort und Stelle der Tragplatte (54).
